# EUROPEAN PATENT SPECIFICATION

(11) **EP 1 274 660 B1**
(45) Date of publication and mention of the grant of the patent: **23.03.2005**
(21) Application number: 01919046.1
(22) Date of filing: 18.04.2001
(51) Int. Cl.: C03C 17/34, C23C 14/34

(54) **METHOD FOR APPLYING AN ANTIREFLECTION COATING TO INORGANIC OPTICALLY TRANSPARENT SUBSTRATES**
VERFAHREN ZUR HERSTELLUNG EINER ENTSPIEGELUNGSSCHICHT AUF ANORGANISCHEN DURCHSICHTIGEN SUBSTRATEN
PROCEDE D'APPLICATION DE REVETEMENT ANTIREFLECHISSANT A DES SUBSTRATS INORGANIQUES OPTIQUEMENT TRANSPARENTS

(30) Priority: 19.04.2000 EP 00810345
(43) Date of publication of application: 15.01.2003
(73) Proprietor: Blösch Ressourcen AG, 2540 Grenchen (CH)
(72) Inventor: ZIMMERMANN, Heinrich, CH-2540 Grenchen (CH); WITTEL, Birgit, CH-2540 Grenchen (CH)
(74) Representative: AMMANN PATENTANWÄLTE AG BERN AMMANN INGENIEURS-CONSEILS EN PROPRIETE INTELLECTUELLE SA BERNE AMMANN PATENT ATTORNEYS LTD BERNE
(86) International application number: PCT/CH2001/000244
(87) International publication number: WO 2001/079130

(56) References cited:
- EP-A- 0 928 977
- WO-A-93/04993
- DE-A- 4 033 881
- GB-A- 2 344 600
- US-A- 4 006 340
- US-A- 5 866 263
- PATENT ABSTRACTS OF JAPAN vol. 006, no. 044 (C-095), 19 March 1982 (1982-03-19) & JP 56 160345 A (SEIKO INSTR & ELECTRONICS LTD), 10 December 1981 (1981-12-10)
- PATENT ABSTRACTS OF JAPAN vol. 014, no. 422 (P-1104), 12 September 1990 (1990-09-12) & JP 02 165101 A (CHICHIBU CEMENT CO LTD), 26 June 1990 (1990-06-26)
- CLAESSON Y ET AL: "OPTICAL CHARACTERISATION OF TITANIUM-NITRIDE-BASED SOLAR CONTROL COATINGS" SOLAR ENERGY MATERIALS,NL,ELSEVIER SCIENCE PUBLISHERS B.V. AMSTERDAM, vol. 20, no. 5 / 06, 1 June 1990 (1990-06-01), pages 455-465, XP000135053

## Description

The present invention relates to a method for applying an antireflection coating according to the preamble of claim 1. The invention further relates to products obtained with the method.

Antireflection coatings are known and are being industrially manufactured worldwide mainly on natural or synthetic eyeglass lenses and on lenses of all kinds for various applications in fine optics. Such antireflection coatings may comprise a single layer or multiple layers composed of pairs of materials having high and low refractive indices, such as TiO₂, SiO₂, HfO₂, MgF₂, etc., which are preferably applied currently by vacuum evaporation, or also by sputtering. The refractive indices of the cited dielectric materials are ideal if they are deposited on substrates whose own refractive indices are comprised between 1.5 and 2.1. The only disadvantage of vacuum-evaporated coatings is their relatively low hardness and therefore a quick abrasion and scratching of the coated surfaces in the case of mechanical interaction with the environment (a problem that is well known to wearers of glasses).

Antireflection coatings have been used in the watch industry since the 80s, but in the beginning only on natural glass watch-glasses, i. e. glasses made of inorganic or mineralic material, for professional wristwatches of the chronometer type. With the introduction of largely scratch-resistant watch glasses made of sapphire glass (monocrystalline aluminum oxide), antireflection coatings have become more important since in the uncoated condition, the overall reflection of these glasses is 6.5% higher than that of natural glass. In the case of sapphire glass with its high optical density (refractive index) of 1.77, the reflection amounts to 7.7% on each side, i.e. to a total of 15.4%. The readability of the dial is therefore deteriorated by a factor of 2, which is being noticed and increasingly criticized by consumers.

Today, the "safe" way of providing sapphire watch glasses with antireflection coatings is to apply them by vacuum evaporation to the inner side of the glass only, with the result that the total reflection is reduced from 15.4% to 7.7% and thus comprised in the order of an uncoated natural glass (8.4%). In this case, the outer, uncoated side conserves the high scratching resistance of the sapphire glass.

Two-sided coatings are also applied. These allow an optimum readability of the time with a residual reflection of less than 1%, which represents a significant improvement over watch glasses which are not coated on both sides. However, an outer antireflection coating deposited by conventional high vacuum evaporation has a substantially smaller resistance to abrasion than sapphire glass. Yet, the sensitivity to scratching is greatly influenced by the shape of the glass. Thus, a flat glass will be scratched much less than a curved one since it has fewer exposed surfaces. Therefore, in practice, the construction of a watch and its design also enter into the decision whether to apply a double-sided coating or not.

Even so, the basic disadvantage of the known antireflection coatings subsists, namely their substantially reduced resistance to abrasion from the underlying material. This is especially true in the case of sapphire glass, which is used for watches precisely because of its mechanical resistance.

Among other properties, the known antireflection coatings distinguish themselves by their high optical quality (*low residual reflection, low dispersion, and no absorption*). Since the resistance of coatings of high optical quality has been considered as secondary, known coatings of this kind have a low mechanical resistance.

Therefore, the main object of the present invention is to provide a method allowing to provide a sapphire glass substrate with an antireflection coating whose scratching resistance approximately corresponds to that of the substrate and which offers a high optical quality (more particularly a low residual reflection).

Such a method is defined in claim 1. Preferred embodiments and products obtained with the method are defined in the dependent claims. For the first time, the method of the invention allows the application of an antireflection coating to sapphire glass without noticeably affecting its scratching resistance.

In the context of the invention, the term "natural glass" generally designates optically transparent, inorganic materials.

Accordingly, such a coating is essentially produced by sputtering. Sputtering techniques (PEPVD) are not yet used in thin film technology for watch industry related optics as the control of the layer thickness is more difficult than in conventional vacuum evaporation techniques. However, it has been found that the hardness and the density of the applied layers can be increased if the coated objects are positioned closer to the target and suitable coating materials are used.

The invention will be further explained by means of an exemplary embodiment and with reference to the Figures.
- FIG. 1: schematically shows a sputtering installation; and
- FIG. 2: schematically shows the procedure allowing to determine the diameter in the case of non-circular targets.

### Layer materials

It has been found that in order to obtain a high scratching resistance, the layers must consist of materials having the highest possible hardness. A pair which meets these requirements is SiO₂/Si₃N₄ (silicon dioxide/silicon nitride). However, the difference of the refractive indices of this combination (SiO₂: 1.46; Si₃N₄: 2.0) is smaller than that of conventional combinations (e.g. TiO₂: 2.35; SiO₂: 1.46) and therefore requires thicker layers while its residual reflection is greater.

Surprisingly, these thicker layers can also be produced in the necessary quality by sputtering. Another advantage of this combination is that only one sputtering target is required and that the type of layer can be selected by changing the reaction gas only. The sequence and the thickness of the layers required for an antireflection coating are determined according to the usual rules of thin film optics. Preferably, at least 2 layers of a material having a high refractive index and a material having a low refractive index are applied while the low-refractive layer is applied last. A further improved effect over the applicable spectral range is obtained e.g. with 4 layers, namely, starting from the substrate, Si₃N₄/SiO₂/Si₃N₄/SiO₂. Furthermore, the chemical resistance of these layer materials is improved over that of conventional layers. However, the coating may still be removed by the action of chemical substances without damaging the substrate.

A further increase of the resistance can be obtained by applying an additional thin protection layer. The protection layer is substantially thinner than any one of the layers of the antireflection coating and preferably no more than half as thick as the thinnest one.

Another possible layer combination of a high hardness is AlN/Al₂O₃, whose refractive indices are equal to 2.08 and 1.67, respectively. The residual reflection is higher than that of conventional combinations, but the hardness of the top layer is optimum.

### Layer production

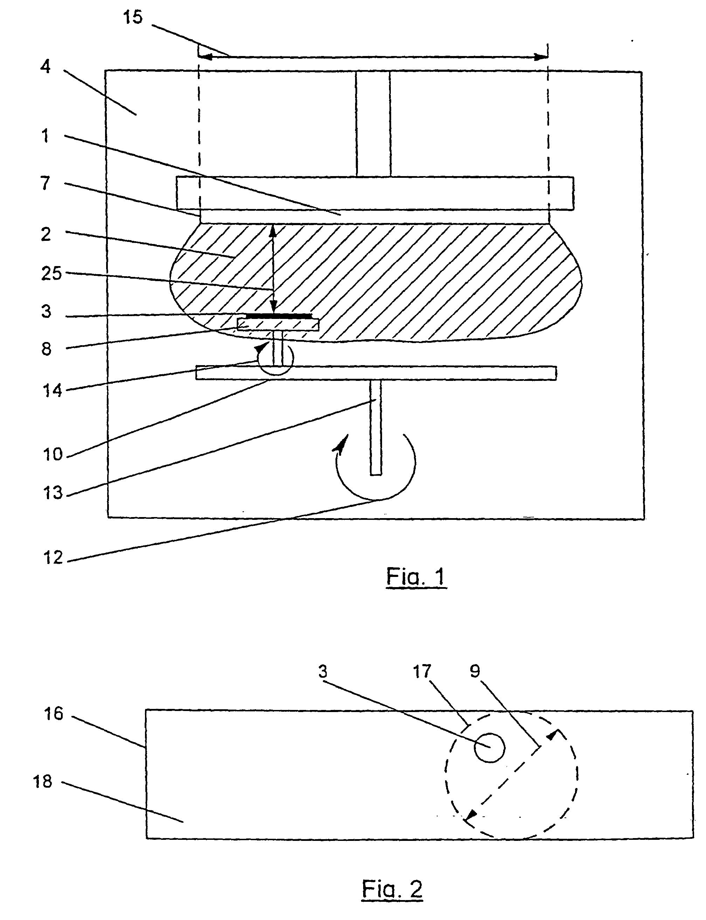

Figure 1 schematically shows a sputtering installation 4. A substrate 3, e.g. of sapphire glass, is disposed relatively close to target 1. Hitherto, this area of the plasma 2 has been considered as unsuitable for coatings since it involves a high thermal load of the objects, on one hand, and since the coating is still very irregular as the density of the plasma strongly varies in function of the location. As a result, the layer growth will be higher in areas close to the center of target 1 than in more distant areas, i.e. closer to the edge 7 of target 1.

It has been found that sapphire glass and also other kinds of natural glass are capable of resisting this thermal load, and that it is therefore possible to produce very dense and thus hard layers with sputtering techniques. In the sputtering process of the invention, the substrates reach temperatures between 300 °C and 400 °C, and in the case of isolated substrates, up to 600 °C. For a regular layer thickness, which is a necessary condition for a high optical quality, the object may be moved in front of the target, thereby allowing to equalize the layer growth.

To this end, the substrates 3 are disposed on supports 8 which are rotatably mounted on a plate 10. During the coating process, plate 10 is rotated about axis 13 according to arrow 12, while supports 8 and thus substrates 3 are simultaneously rotated according to arrow 14. The rotational movement of supports 8 may be produced by a dedicated driving unit, or it may be derived from the rotation of plate 10 e.g. by a gear assembly. Drives and gear assemblies of this kind are known *per se.* Plate 10 preferably comprises as many supports 8 as possible, thus allowing the simultaneous coating of a great number of substrates.

For an improved adhesion of the layers to the substrates, the latter are preheated prior to the sputtering process. Presumably, the advantageous effect of the preheating phase in the process according to the invention is due to the resulting reduction of the temperature difference between the plasma and the substrate especially at the beginning of the sputtering operation.

The ratio of the distance d_{ST} 25 between the substrate and the target and of the diameter of the (circular) target q 15 may serve as a measure for determining the position of the substrate 3 with respect to the target 1. Thus, for example, d_{ST}/q = 1 is a rather large distance, while preferred values are in the vicinity of 1/2, preferably 1/3 or smaller. If a position other than above the center of the target is chosen, the distance may have to be reduced so that the substrate is positioned in an area where the plasma density is the same as or higher than if it were positioned above the center according to the cited rule.

In the case of non-circular targets such as the rectangular target 16 of Figure 2, diameter q 15 is determined by the diameter of a disk of a size that still fits on target 16. In other words, it is equal to incircle 17 of target surface 18. For this purpose, incircle 17 or the equivalent disk must be located under substrate 3.

In spite of the high initial costs, the sputtering technique offers important advantages with respect to such properties as hardness and abrasion resistance of the coating.
Compared to conventionally evaporated coatings, the density and hardness of sputtered coatings are much higher.

However, the hardness of the layers is almost impossible to determine in practice. On account of the low thickness of the layers, *inter alia,* current measuring procedures essentially measure the hardness of the substrate or else yield artifacts. Consequently, since the standard Bayer Test does not noticeably affect the layers, the mechanical resistance has been measured by a "tightened" Bayer Test of the abrasion and scratching resistance.

In the Bayer Abrasion Test according to ASTM F735-94, the test substrates, e.g. of synthetic glass, are placed on the bottom of a metal trough and covered with a specified amount of quartz sand. By means of a shaking device, the trough is subjected to 100 to 600 shaking cycles ("strokes") of a specified frequency and amplitude. The increase in light dispersion as compared to the uncoated substrate constitutes a measure of the scratching resistance.

### Example 1

Respective lenses of sapphire glass and of natural glass are positioned at a distance of 60 mm from a target having a diameter of 125 mm, and provided with an antireflection coating composed of alternating layers of silicon nitride and silicon oxide by reactive sputtering of silicon with oxygen and nitrogen, respectively, at a process pressure of p = 5·10⁻³ mBar, the first two layers having a physical thickness of 20 nm each, and the last two layers having a physical thickness of 90 and 120 nm, respectively. The abrasion resistance was measured with the mentioned Bayer Test according to ASTM F 735-94 with tightened test conditions as follows:

### Tightened Bayer-Test

- corundum sand instead of quartz sand;
- 13.500 strokes instead of 600;
- stroke length 60 mm instead of 50 mm;
- sand layer height 25 mm instead of 13 mm; and
- frequency 450 min⁻¹ instead of 300 min⁻¹.

For comparison purposes, an uncoated substrate and a substrate with a conventional evaporated coating were also measured.

The following results were obtained:

**Table 1:**

| increase in light dispersion of the transparent substrate after the tightened Bayer Test | |
|---|---|
| Substrate | Light dispersion value |
| Sapphire | 0.1 % |
| Sapphire coated according to the invention | 0.2 % |
| Sapphire with conventional coating (evaporated) | coating completely removed |
| Natural glass | 0.7 % |
| Natural glass coated (outside of the invention) | 0.4 % |

### Example 2

A sapphire glass lens is positioned at a distance of 75 mm from a target having a diameter of 125 mm, and provided with an antireflection coating composed of alternating layers of silicon nitride and silicon oxide by reactive sputtering of silicon with oxygen and nitrogen, respectively, at a process pressure of p = 5·10⁻³ mBar, the first two layers having a physical thickness of 20 nm each, and the last two layers having a physical thickness of 90 and 120 nm, respectively. The abrasion resistance was measured with the tightened Bayer Test (see Example 1). The following results were obtained:

**Table 2:**

| increase in light dispersion of the transparent substrate after the tightened Bayer Test | |
|---|---|
| Substrate | Light dispersion value |
| Sapphire | 0.1 % |
| Sapphire coated outside of the invention | 0.4 % |

### Example 3

A sapphire lens is positioned at a distance of 80 mm from a target having a diameter of 125 mm, and provided with an antireflection coating composed of alternating layers of silicon nitride and silicon oxide by reactive sputtering of silicon with oxygen and nitrogen, respectively, at a process pressure of p = 5·10⁻³ mBar, the first two layers having an optical thickness of 20 nm each, and the last two layers having an optical thickness of 90 and 120 nm, respectively. The abrasion resistance was measured with the tightened Bayer Test (see Example 1). The following results were obtained:

**Table 3:**

| increase in light dispersion of the transparent substrate after the tightened Bayer Test | |
|---|---|
| Substrate | Light dispersion value |
| Sapphire | 0.1 % |
| Sapphire coated outside of the invention | coating completely removed |

The coatings obtained according to Example 1 may be considered as largely scratch-resistant. The increase in light dispersion of 0.1 % with respect to pure sapphire glass, i.e. to the double of the value, is not visible by the naked eye. In contrast, the increase in light dispersion of the lens of Example 2 is already apparent. The results of Example 3 speak for themselves. However, it will be noted that the test objects are subject to substantially higher requirements in the applied tightened Bayer Test than in practice. Thus, depending on the requirements, a coating according to Example 3 may still be sufficient. On the other hand, an even smaller distance allows to obtain a further increased scratching resistance.

On natural glass, the coating of the invention even allows an improvement of the scratching resistance over the uncoated substrate (Example 1).

### Example 4

In another practical example, a magnifying lens of sapphire glass for use on a watch glass was coated. The magnifying lens of a diameter of 7 mm has a relatively important curvature, which has to be taken into account in the coating procedure since a variation of 2% of the coating thickness is optically visible already.

As mentioned in the introduction, the important curvature also leads to an increased sensitivity to mechanical wear.

In spite of the important curvature, the examination of the coated magnifying lens showed a high optical quality without noticeable shortcomings in comparison to the more unproblematic lenses of Examples 1 to 3.

From the description of the method of the invention and of the coatings produced with the method, modifications and adaptations are apparent to those skilled in the art without leaving the protective scope of the claims. Thus, *inter alia,*
- other layers can be applied to sapphire glass substrates in order to produce an antireflection coating of a high hardness, the properties relevant for abrasion and scratching resistance being adjusted through the process parameters of the sputtering operation and the choice of the layer compositions;
- other layer combinations of base materials having a high hardness can be used, particularly also of materials of different absorption in the visible spectrum, thus allowing to obtain color effects, e.g. ZrN/ZrO₂;
- the antireflection coating may be composed of a different number of layers equal to or greater than two, also of an odd number of layers, e.g. 5; and
- layers of other material pairs and/or of several material pairs can be applied, e.g. two layers of SiO₂/AlN, a succession of layers of SiO₂/Si₃N₄/Al₂O₃/AlN, or another succession of different material pairs.

### Glossary

- PEPVD: plasma-enhanced physical vapor deposition
- PVD: physical vapor deposition

## Claims

1. A method for applying an antireflection coating to a substrate of sapphire glass, which is an optically transparent, inorganic material, wherein alternating layers of different refractive indices are applied to the substrate by means of a plasma-enhanced PVD process, more particularly by so-called sputtering, the distance between the target and the substrate being chosen such that the scratching resistance of the obtained layers is similar to or higher than that of the substrate so that the light dispersion of the applied antireflection coating, measured by the "tightened Bayer Test" defined in the description, is no more than twice as high as that of the uncoated sapphire glass.

2. The method of claim 1, wherein said layers are composed of at least two of the following materials: SiO₂, Si₃N₄, Al₂O₃, AlN, ZrN, ZrO₂, of which SiO₂ and Si₃N₄ are preferred.

3. The method of claim 1, wherein said layers are composed of at least one of the following pairs: SiO₂ and Si₃N₄, Al₂O₃ and AlN, ZrN and ZrO₂, SiO₂/Si₃N₄ being the preferred pair.

4. The method of claim 1, wherein the ratio of the distance d_{ST} between said substrate and the target and of the target diameter q is equal to 1 at the most if said substrate is positioned approximately opposite the center of the target, said diameter being determined in non-circular targets by the largest circle fitting on the target surface under said substrate, and if said substrate is positioned otherwise, said distance is chosen such that the plasma density at the location of said substrate is the same as or greater than in the case of said central positioning.

5. The method of claim 4, wherein said ratio is not greater than 1/2 (one half), preferably no greater than 1/3 (one third).

6. The method of claim 1, wherein said substrates are preheated prior to the coating operation in order to improve the adhesion of the layers.

7. The method of claim 1, wherein a protection layer is applied as the last layer in order to increase the chemical stability, said protection layer being substantially thinner than and preferably no more than half as thick as the thinnest one of the antireflection coating layers.

8. The method of claim 7, wherein said protection layer consists of one of the following materials: Si₃N₄, ZrN, Al₂O₃, ZrO₂.

9. A watch glass of sapphire glass, wherein at least a part of the surface, preferably a magnifying lens, or the entire surface is provided with an antireflection coating produced according to the method of claim 1.

10. The watch glass of claim 9, wherein the scratching resistance of said antireflection coating is essentially equal to or higher than that of the watch glass material, and in the case of a multilayer antireflection coating, each one of the individual layers thereof has this property.

11. The watch glass of claim 9, wherein said antireflection coating is essentially color-neutral.

12. A watch provided with the watch glass of claim 11.

## Patentansprüche

1. Verfahren zur Herstellung einer Entspiegelungsschicht auf einem Substrat aus Saphirglas, das ein optisch transparentes, anorganisches Material ist, wobei wechselweise Schichten verschiedenen Brechungsindexes mittels eines plasmaunterstützten PVD-Verfahrens, insbesondere durch "Sputtern", auf das Substrat aufgebracht werden, wobei der Abstand zwischen Target und Substrat so gewählt wird, dass die erhaltenen Schichten eine Kratzfestigkeit ähnlich oder höher als das Substrat aufweisen, so dass der Streulichtwert der aufgebrachten Entspiegelungsschicht, gemessen mit dem in der Beschreibung definierten "verschärften Bayer-Test", nicht höher als doppelt so hoch ist wie derjenige des unbeschichteten Saphirglases.

2. Verfahren nach Anspruch 1, wobei die Schichten aus mindestens zweien der folgenden Materialien hergestellt werden: SiO₂, Si₃N₄, Al₂O₃, AlN, ZrN, ZrO₂, wobei SiO₂ und Si₃N₄ bevorzugt sind.

3. Verfahren nach Anspruch 1, wobei die Schichten aus mindestens einer der folgenden Paarungen bestehen: SiO₂ und Si₃N₄, Al₂O₃ und AlN, ZrN und ZrO₂, wobei die Paarung SiO₂/Si₃N₄ bevorzugt ist.

4. Verfahren nach Anspruch 1, wobei das Verhältnis zwischen dem Abstand d_{ST} des Substrats vom Target und dem Durchmesser q höchstens 1 beträgt, wenn das Substrat in etwa gegenüber dem Zentrum des Targets angeordnet ist, wobei der Durchmesser q bei anderen als kreisförmigen Targets durch den grösstmöglichen, auf die Oberfläche des Targets unter dem Substrat aufzeichenbaren Kreis bestimmt ist, und bei anderer Anordnung des Substrats der Abstand d_{ST} so gewählt ist, dass die Plasmadichte am Ort des Substrats gleich oder grösser als bei genannter zentraler Positionierung ist.

5. Verfahren nach Anspruch 4, wobei das genannte Verhältnis höchstens 1/2, bevorzugt höchstens 1/3 ist.

6. Verfahren nach Anspruch 1, wobei die Substrate vor dem Beschichten vorgeheizt werden, um die Haftung der Schichten zu verbessern.

7. Verfahren nach Anspruch 1, wobei als letzte Schicht eine Schutzschicht aufgebracht wird, um die chemische Beständigkeit zu erhöhen, wobei die Schutzschicht deutlich dünner als und bevorzugt maximal halb so dick wie die dünnste der Schichten der Antireflexschicht ist.

8. Verfahren nach Anspruch 7, wobei die Schutzschicht aus einem der folgenden Materialien besteht: Si₃N₄, ZrN, Al₂O₃, ZrO₂.

9. Uhrenglas aus Saphirglas, wobei mindestens ein Teil der Oberfläche, bevorzugt eine Lupe, oder die gesamte Oberfläche mit einer Entspiegelungsschicht versehen ist, die nach dem Verfahren nach Anspruch 1 hergestellt ist.

10. Uhrenglas nach Anspruch 9, wobei die Entspiegelungsschicht eine Kratzfestigkeit im wesentlichen gleich zum oder höher als das Material des Uhrenglases aufweist und im Fall einer mehrschichtigen Entspiegelungsschicht die einzelnen Schichten für sich diese Eigenschaft aufweisen.

11. Uhrenglas nach Anspruch 9, wobei die Entspiegelungsschicht im wesentlichen farbneutral ist.

12. Uhr mit einem Uhrenglas nach Anspruch 11.

## Revendications

1. Procédé d'application d'un revêtement antireflet à un substrat en verre saphir, qui est un matériau inorganique optiquement transparent, où des couches alternantes ayant différents indices de réfraction sont appliquées au substrat par un procédé PVD assisté par plasma, plus particulièrement par procédé dénommé "sputtering", la distance entre la cible et le substrat étant choisie telle que la résistance aux rayures des couches obtenues est similaire ou supérieure à celle du substrat, de sorte que la dispersion lumineuse du revêtement antireflet appliqué, mesurée par le "test Bayer à difficulté renforcée", défini dans la description, ne soit pas supérieure au double de celle du verre saphir non revêtu.

2. Procédé selon la revendication 1, où lesdites couches sont composées d'au moins deux matériaux parmi les suivants: SiO₂, Si₃N₄, Al₂O₃, AlN, ZrN, ZrO₂, dont SiO₂ et Si₃N₄ sont préférés.

3. Procédé selon la revendication 1, où lesdites couches sont composées d'au moins une paire parmi les paires suivantes: SiO₂ et Si₃N₄, Al₂O₃ et AlN, ZrN et ZrO₂, SiO₂/Si₃N₄ étant la paire préférée.

4. Procédé selon la revendication 1, où le rapport entre la distance d_{ST} du substrat à la cible et le diamètre q de la cible est égal à 1 au plus si ledit substrat est positionné approximativement en face du centre de la cible, ledit diamètre étant déterminé en cas de cibles non circulaires par le cercle le plus grand pouvant être inscrit sur la surface de la cible sous ledit substrat, et si ledit substrat est positionné autrement, ladite distance étant choisie telle que la densité du plasma à l'endroit dudit substrat est la même ou plus grande que dans le cas dudit positionnement central.

5. Procédé selon la revendication 4, où ledit rapport n'est pas supérieur à 1/2 (un demi), de préférence non supérieur à 1/3.

6. Procédé selon la revendication 1, où lesdits substrats sont préchauffés avant le revêtement pour améliorer l'adhérence des couches.

7. Procédé selon la revendication 1, où une couche protectrice est appliquée en dernier pour augmenter la stabilité chimique, ladite couche protectrice étant substantiellement plus mince que la couche la plus mince du revêtement antireflet et son épaisseur étant préférablement égale à la moitié de celle-ci au plus.

8. Procédé selon la revendication 7, où ladite couche protectrice est constituée d'un des matériaux suivants: Si₃N₄, ZrN, Al₂O₃, ZrO₂.

9. Glace en verre saphir, où une partie au moins de la surface, préférablement une loupe, ou la surface entière est munie d'un revêtement antireflet produit avec le procédé selon la revendication 1.

10. Glace selon la revendication 9, où la résistance aux rayures dudit revêtement antireflet est essentiellement égale ou supérieure à celle du matériau de la glace, et que chacune des couches individuelles présente cette propriété dans le cas d'un revêtement antireflet à couches multiples.

11. Glace selon la revendication 9, où le revêtement antireflet est de couleur essentiellement neutre.

12. Montre munie d'une glace selon la revendication 11.
